# EUROPÄISCHE PATENTSCHRIFT

(11) **EP 3 189 716 B1**
(45) Veröffentlichungstag und Bekanntmachung des Hinweises auf die Patenterteilung: **23.12.2020**
(21) Anmeldenummer: 15748034.4
(22) Anmeldetag: 06.08.2015
(51) Int. Cl.: H05K 5/00

(54) **STEUERGERÄTEVORRICHTUNG FÜR EIN KRAFTFAHRZEUG SOWIE VERFAHREN ZUM HERSTELLEN EINER SOLCHEN**
CONTROL UNIT DEVICE FOR A MOTOR VEHICLE AND A METHOD FOR PRODUCING SAME
DISPOSITIF DE COMMANDE POUR UN VÉHICULE À MOTEUR, ET PROCÉDÉ DE FABRICATION D'UN TEL DISPOSITIF

(30) Priorität: 03.09.2014 DE 102014217552
(43) Veröffentlichungstag der Anmeldung: 12.07.2017
(73) Patentinhaber: Vitesco Technologies Germany GmbH, 30165 Hannover (DE)
(72) Erfinder: ALBERT, Andreas, 91315 Höchstadt/Aisch (DE); BAUER, Gerhard, 91322 Gräfenberg (DE); HENNIGER, Jürgen, 91056 Erlangen-Dechsendorf (DE); KEUTEN, Matthias, 90518 Altdorf (DE); NOVAK, Michael, 90425 Nürnberg (DE); SCHUCH, Bernhard, 91616 Neusitz (DE); WIECZOREK, Matthias, 91233 Neunkirchen am Sand (DE)
(74) Vertreter: Waldmann, Georg Alexander
(86) Internationale Anmeldenummer: PCT/EP2015/068210
(87) Internationale Veröffentlichungsnummer: WO 2016/034362

(56) Entgegenhaltungen:
- WO-A1-2008/049724
- DE-A1-102010 026 954
- DE-A1-102012 204 004
- DE-A1-102012 213 916
- DE-T2- 69 218 074
- JP-A- 2007 216 836

## Beschreibung

Die Erfindung betrifft eine Steuergerätevorrichtung für ein Kraftfahrzeug. Des Weiteren betrifft die Erfindung ein Verfahren zum Herstellen einer Steuergerätevorrichtung.

In Kraftfahrzeugen werden Steuergerätevorrichtungen mit beispielsweise einer elektronischen Steuerschaltung und zugehörige elektronische Komponenten wie Sensoren für unterschiedliche Aufgaben eingesetzt. Beispielsweise werden Sensoren in einem Getriebe eingesetzt, um Drehzahlen von Wellen und Positionen von Gangstellern zu ermitteln. Die Steuergerätevorrichtungen enthalten beispielsweise eine Steuerlogik, einen oder mehrere Mikroprozessoren und weitere Elemente, um Messwerte der Sensoren auszuwerten und Gangsteller, insbesondere Ventile zu betätigen. Vermehrt werden die Steuergerätevorrichtungen direkt an den zu steuernden Komponenten eines Fahrzeugs verbaut, um beispielswiese Kabelbäume zu vermeiden oder zu reduzieren. Insbesondere Steuergerätevorrichtungen für ein Getriebe werden direkt in dem Getriebe oder an dem Getriebe angeordnet. Im Betrieb sind die Steuergerätevorrichtungen widrigen Umgebungsbedingungen ausgesetzt. Typischerweise liegen hohe Temperaturen von beispielsweise bis zu 150° und/oder hohe Drücke vor. Zusätzlich sind die Steuergerätevorrichtungen regelmäßig heißen und/oder aggressiven Ölen ausgesetzt.

Die WO 2008 049 724 A1 beschreibt ein Gehäuse für ein elektronisches Steuergerät. Das Gehäuse weist mindestens zwei Gehäuseteile auf, welche mindestens einen Gehäuseboden, einen Gehäusedeckel und eine elektronische Verbindung zwischen im Gehäuseinnenraum angeordneten Bauteilen und außerhalb des Gehäuses liegenden Komponenten umfasst, die auf dem Gehäuseboden fixiert ist. Der Gehäusedeckel ist direkt auf der elektronischen Verbindung aufgelötet und ermöglicht auf diese Weise eine dauerhaft hermetisch abgedichtete Durchführung der elektronischen Verbindung.

Die DE 20 1010 026954 A1 beschreibt ein Gehäuse einer elektronische Schaltung für eine Kraftstoffpumpe. Das Gehäuse besteht aus einem Boden und einem mit dem Boden verbundenen Deckel, einer Leiterplatte und auf einer Seite der Leiterplatte angeordnete elektrische und/oder elektronische Bauelemente. Auf der Seite der Leiterplatte, auf der die Bauelemente angeordnet sind, ist eine in sich geschlossene metallische Bahn angeordnet, wobei die Bauelemente in dem von der Bahn umschlossenen Bereich angeordnet sind, ein Deckel mittels Lötverbindung mit der geschlossenen Bahn derart verbunden ist, dass die Leiterplatte als Boden und der Deckel ein Gehäuse bilden, und dass die Leiterplatte mindestens eine Sperrlage aufweist.

Die JP2007216836 beschreibt ein Gehäuse für ein Fahrzeugsteuergerät mit einem zweigeteilten Deckel, der an einer Leiterplatte anliegt. Ein Teil des Deckels beherbergt einen mit Bauelementen bestückten Teil der Leiterplatte und der andere Teil einen mit einem Steckverbinder bestückten Teil der Leiterplatte.

Eine Aufgabe, die der Erfindung zugrunde liegt, ist es, eine Steuergerätevorrichtung und ein Verfahren zum Herstellen einer solchen zu beschreiben, welche zu einem zuverlässigen Betrieb der Steuergerätevorrichtung beiträgt.

Die Aufgabe wird gelöst durch die unabhängigen Patentansprüche. Bevorzugte Ausgestaltungen der Erfindung sind in den abhängigen Patentansprüchen angegeben.

Gemäß einem ersten Aspekt der Erfindung wird eine Steuergerätevorrichtung für ein Kraftfahrzeug beschrieben, welche eine Leiterplatte aufweist. Auf der Leiterplatte sind mehrere elektronische Komponenten angeordnet, welche elektrisch miteinander über Leiterbahnen der Leiterplatte gekoppelt sind. Weiter weist die Steuergerätevorrichtung einen im Wesentlichen gasundurchlässigen Deckel auf, welcher stoffschlüssig mit der Leiterplatte derart verbunden ist, dass dieser mit der Leiterplatte einen abgeschlossenen Hohlraum bildet, in welchem sich die elektronischen Komponenten und die zugehörigen Leiterbahnen befinden.

Die elektronischen Komponenten umfassen beispielsweise Kondensatoren, Spulen, einen Mikroprozessor oder dergleichen, die auf der Leiterplatte angeordnet sind und miteinander in elektrischer Wirkverbindung stehen. Beispielsweise sind die elektronischen Komponenten über Leiterbahnen der Leiterplatte und/oder mittels gebondeter Golddrähte miteinander elektrisch gekoppelt.

Der Deckel, welcher gas- und auch fluidundurchlässig ist, schützt die elektronischen Komponenten der Steuergerätevorrichtung vor Ölen, insbesondere aggressiven Ölen, sowie schadhaften Gasen und Chemikalien. Weiterhin sind die elektronischen Komponenten vor Salzen oder Verarbeitungsrückständen geschützt. Die Öle, Gase, Salze und/oder Rückstände liegen beispielsweise in einem Getriebe vor, an welchem oder innerhalb welchem die Steuergerätevorrichtung angeordnet ist. Auch die entsprechenden Leiterbahnen werden von dem Deckel geschützt. Hierzu ist Deckel stoffschlüssig mit der Leiterplatte so verbunden, dass mit der Leiterplatte ein abgeschlossener Hohlraum um die elektronischen Komponenten gebildet wird. Mit anderen Worten ist um die elektronischen Komponenten und/oder die weiteren elektronischen Komponenten sowie die entsprechenden Leiterbahnen eine geschlossene, umlaufende stoffschlüssige Verbindungsnaht ausgebildet. Im Gegensatz zu formschlüssig verbundenen Deckeln können im Wesentlichen keine Fluide und/oder Gase in den Hohlraum eintreten. Somit sind die elektronischen Komponenten versiegelt und gegen die Umwelt abgedichtet. Zusätzlich kann auf gummiartige Dichtungen verzichtet werden, welche insbesondere bei formschlüssigen Deckeln verwendet werden. Diese Dichtungen würden keine vollständige Gasdichtigkeit garantieren, da die Gase durch derartige Dichtungen in erheblichem Maße diffundieren können.

Beispielsweise umfassen die Chemikalien beziehungsweise Gase Schwefelverbindungen, wodurch Sulfide entstehen können. Sulfide sind zumindest teilweise stromleitend und würden sich an ungeschützten elektronischen Komponenten, den Leiterbahnen der Leiterplatte und/oder den Golddrähten ablagern. Dabei kann es zu chemischen Reaktionen mit den Sulfiden kommen. Beispielsweise oxidieren die Leiterbahnen der Leiterplatte, insbesondere Silberleiterbahnen, mit den Schwefelverbindungen. Dabei können sich Leitungswiderstände und/oder Funktionen der elektronischen Komponenten verändern und beispielsweise das Schaltverhalten eines Getriebes negativ beeinflussen. Weiterhin können derartige Gase Signalveränderungen bewirken, sodass es beispielsweise zu fehlerhaften Auswertungen durch die Steuergerätevorrichtung kommt.

Insgesamt wird somit mittels des beschriebenen, stoffschlüssig mit der Leiterplatte verbundenen Deckels eine Lebensdauer und Genauigkeit der Steuergerätevorrichtung verbessert. Weiter ist die beschriebene Steuergerätevorrichtung als vorgefertigtes Modul für eine Anwendung vorort wie beispielsweise im Getriebe oder als Anbausteuergerät realisierbar.

Gemäß einer Ausgestaltung ist die stoffschlüssige Verbindung zwischen dem Deckel und der Leiterplatte mittels Schweißen hergestellt.

Gemäß einer weiteren Ausgestaltung ist die stoffschlüssige Verbindung zwischen dem Deckel und der Leiterplatte mittels Löten hergestellt, wobei eine Metalllage der Leiterplatte mittels eines Lots mit dem Deckel verlötet ist. Unter der Metalllage werden beispielsweise ein oder mehrere Leiterbahnen der Leiterplatte verstanden, welche mit Hilfe des Lots mit dem Deckel verlötet werden. Die Metalllage ist beispielsweise eine Kupferlage. Das Lot umfasst metallische Lotstoffe, wie beispielsweise Zinn.

Gemäß einer weiteren Ausgestaltung umfasst das Löten ein Laserlöten. Mittels des Laserlötens ist es möglich, die zum Löten notwendige Wärme lokal und somit punktuell in die entsprechenden, zu verlötenden Bereiche einzubringen. Durch das lokale Einbringen von Wärme wird im Gegensatz zum Löten innerhalb von Lötöfen oder Heißtunneln vermieden, dass die gesamte Steuergerätevorrichtung stark erhitzt wird. Durch ein Erwärmen der gesamten Steuergerätevorrichtung könnten sich andere mit der Leiterplatte verbundene Bauteile, wie beispielsweise Kondensatoren, von der Leiterplatte lösen.

Gemäß einer weiteren Ausgestaltung ist die Metalllage derart versiegelt, dass ein direkter Kontakt der Metalllage mit einer Umgebung des Deckels außerhalb des Hohlraums unterbunden ist. Durch das Versiegeln wird verhindert, dass die bereits erwähnten Gase oder Öle durch chemisches Zersetzen der Metalllage in den Hohlraum und somit in Kontakt zu den elektronischen Komponenten geraten. Beispielsweise können sich die Gase durch die Metalllage "fressen". Dies könnte zusätzlich dazu führen, dass der Deckel nicht mehr ausreichend stoffschlüssig mit der Leiterplatte verbunden ist und sich von dieser löst. Im Betrieb eines Kraftfahrzeuges ist die Steuergerätevorrichtung hohen Temperaturen ausgesetzt, wodurch es zu einem Druckanstieg in dem Hohlraum kommt. Dadurch wirken große Kräfte auf die Leiterplatte und den Deckel ein, denen der Deckel standhalten muss. Mittels der Versiegelung wird sichergestellt, dass sich der Deckel nicht aufgrund der Zersetzung der Metalllage unter den vorherrschenden Drücken und Kräften von der Leiterplatte löst.

Gemäß einer weiteren Ausgestaltung ist die die Metalllage zumindest in einem dem Hohlraum abgewandten Bereich versiegelt, sodass ein Kontakt der Metalllage mit einer Umgebung des Deckels außerhalb des Hohlraums unterbunden ist.

Beispielsweise ist die Metalllage mit einer zusätzlichen Beschichtung versehen und anschließend mit dem Deckel verlötet. Alternativ ist eine Versiegelungsbeschichtung außerhalb des Hohlraums aufgebracht, welche die Leiterplatte und den Deckel derart überlappt, dass die Metalllage außerhalb des Hohlraums nicht freiliegt beziehungsweise Kontakt zur Umgebung des Deckels hat. Die zusätzliche Beschichtung beziehungsweise die Versiegelungsbeschichtung sorgt dafür, dass die Metalllage keinen direkten Kontakt zur Umgebung des Deckels außerhalb des Hohlraums hat. Dadurch wird verhindert, dass die Metalllage aufgrund der Öle oder Gase zersetzt wird, wodurch sich der Deckel von der Leiterplatte lösen und/oder die Gase oder Fluide in den Hohlraum eindringen würden.

Gemäß einer weiteren Ausgestaltung weist der Deckel einen Metallwerkstoff oder einen Kunststoffwerkstoff auf. Bei dem Metallwerkstoff kann es sich beispielsweise um ein lötbares Metall handeln. Der Metallwerkstoff ermöglicht eine stabile Ausgestaltung des Deckels und garantiert eine hohe Fluid- und Gasundurchlässigkeit. Bei Verwenden eines Kunststoffwerkstoffs kann ein besonders leichter und elastischer Deckel ermöglicht werden. Dadurch können beispielsweise die oben erwähnten Druckanstiege innerhalb des Hohlraums durch elastisches Nachgeben des Deckels ausgeglichen werden.

Gemäß einer weiteren Ausgestaltung ist der Deckel an einer der Leiterplatte zugewandten Seite mit einem schweißbaren oder lötbaren Material beschichtet. Beispielsweise bei Verwendung eines Kunststoffwerkstoffes für den Deckel kann dieser zur stoffschlüssigen Verbindung mit der Leiterplatte eine lötbare beziehungsweise schweißbare Beschichtung aufweisen, sodass die stoffschlüssige Verbindung herstellbar ist.

Gemäß einer weiteren Ausgestaltung weist der Deckel eine gasundurchlässige Beschichtung auf. Die gasundurchlässige Beschichtung ist beispielsweise auf einer von dem Hohlraum abgewandten Außenseite des Deckels aufgebracht und begünstigt, dass im Wesentlichen keine Gase und/oder Fluide in den abgeschlossenen Hohlraum eintreten können.

Erfindungsgemäß ist die Leiterplatte auf einem metallischen Grundträger angeordnet. Dadurch lässt sich die Steuergerätevorrichtung über den Grundträger sicher an einem weiteren Bauelement, beispielsweise eine Gehäuse eines Getriebes, mechanisch sicher festlegen. Zusätzlich kann über den metallischen Grundträger Wärme der Steuergerätevorrichtung auf einfache Art und Weise abgeführt werden. Dadurch kann eine Überhitzung der Steuergerätevorrichtung vermieden werden.

Erfindungsgemäß weist die Steuergerätevorrichtung einen Steckverbinder auf, welcher elektrisch gekoppelt mit der Leiterplatte an dem metallischen Grundträger angeordnet ist, wobei der Deckel derart ausgestaltet ist, dass dieser im mit der Leiterplatte verbundenen Zustand den Steckverbinder außerhalb des Hohlraums mechanisch an der dem Grundträger festlegt. Der Steckverbinder ist beispielsweise mittels Pressfit-Kontakten mit der Leiterplatte elektrisch gekoppelt.

Gemäß einem zweiten Aspekt der Erfindung wird ein Verfahren zum Herstellen einer Steuergerätevorrichtung gemäß dem ersten Aspekt der Erfindung beschrieben. Das Verfahren umfasst:
- Bereitstellen der Leiterplatte, auf welcher die elektronischen Komponenten angeordnet sind;
- Bereitstellen des gasundurchlässigen Deckels;
- stoffschlüssiges Verbinden des Deckels mit der Leiterplatte derart, dass dieser mit der Leiterplatte einen abgeschlossenen Hohlraum bildet, in welchem sich die elektronischen Komponenten befinden.
Das Verfahren ermöglicht im Wesentlichen die vorgenannten Vorteile.
Weitere Ausgestaltungen und Vorteile sind in den Unteransprüchen sowie der nachfolgenden, ausführlichen Beschreibung eines Ausführungsbeispiels beschrieben.

Das Ausführungsbeispiel der Erfindung wird nachfolgend unter Bezugnahme auf die Figuren detailliert beschrieben.
In den Figuren zeigen:
- Figur 1: eine schematische Schnittansicht einer Steuergerätevorrichtung gemäß einem illustrativen, nicht erfindungsgemäßen Ausführungsbeispiel,
- Figur 2: eine schematische Schnittansicht einer Steuergerätevorrichtung gemäß einem Ausführungsbeispiel,
- Figur 3: eine schematische Schnittansicht einer Steuergerätevorrichtung gemäß einem illustrativen, nicht erfindungsgemäßen Ausführungsbeispiel und
- Figur 4: ein schematisches Ablaufdiagramm eines Verfahrens zur Herstellung einer Steuergerätevorrichtung gemäß einem der Ausführungsbeispiele.

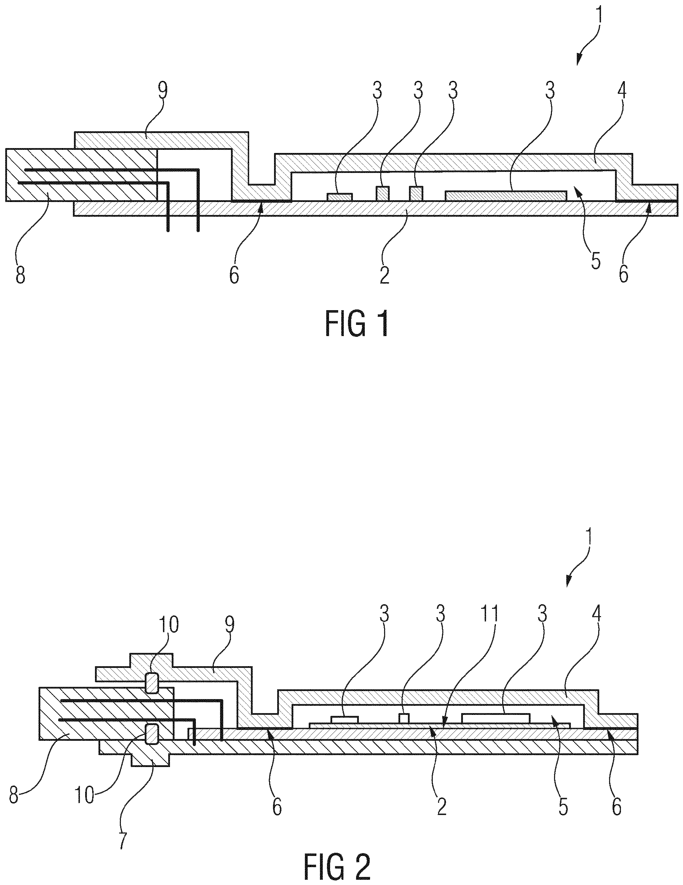

Figuren 1 bis 3 zeigen schematische Schnittansichten einer Steuergerätevorrichtung 1 gemäß dreier Ausführungsbeispiele. Zunächst werden Gemeinsamkeiten der drei Ausführungsbeispiele beschrieben, ehe auf die Unterschiede eingegangen wird.

Bei den Ausführungsbeispielen handelt es sich bei der Steuergerätevorrichtung 1 um eine Steuergerätevorrichtung eines Automatikgetriebes eines Kraftfahrzeuges. Die Steuergerätevorrichtung 1 ist eingerichtet, um beispielsweise Messwerte von Sensoren wie Hall-Sensoren auszuwerten und eine Schaltung des Automatikgetriebes in Abhängigkeit der Messwerte zu steuern. Alternativ kann die Steuergerätevorrichtung 1 auch für andere Einsatzzwecke vorgesehen sein.

Jede Steuergerätevorrichtung 1 weist eine Leiterplatte 2 auf. Auf der Leiterplatte 2 ist eine Mehrzahl von elektronischen Komponenten 3 angeordnet. Diese umfassen beispielsweise Kondensatoren, Spulen, wenigstens einen Mikroprozessor und/oder andere Elemente. Die elektronischen Komponenten 3 sind miteinander elektrisch gekoppelt, insbesondere über gebondete Golddrähte und/oder Leiterbahnen der Leiterplatte 2.

Zum Schutz der elektronischen Komponenten 3 und der entsprechenden Leiterbahnen ist ein gasundurchlässiger Deckel 4 mit der Leiterplatte 2 verlötet. Der Deckel 4 weist einen Metallwerkstoff auf, welcher lötbar ist. Somit ist der Deckel 4 stoffschlüssig mit der Leiterplatte 2 verbunden, wobei dieser mit der Leiterplatte 2 einen abgeschlossenen Hohlraum 5 begrenzt. Somit ist eine zusammenhängende stoffschlüssige Verbindungsnaht zwischen dem Deckel 4 und der Leiterplatte 2 um die elektronischen Komponenten 3 ausgebildet. Der Hohlraum 5 ist somit vollständig versiegelt und gegenüber der Umgebung des Deckels 4 abgedichtet.

Zum Herstellen der stoffschlüssigen Verbindung beziehungsweise der Lötverbindung wird eine Metalllage 6 der Leiterplatte 2 mit dem Deckel 4 verlötet. Hierzu ist ein Lot wie Zinn auf die Metalllage 6 aufgebracht, welches zum Herstellen der Verbindung aufgeschmolzen wird. Die Metalllage 6 umfasst eine oder mehrere Leiterbahnen der Leiterplatte 2. Insbesondere besteht die Metalllage 6 aus einem Kupfermaterial. Das Lot ist für Hochtemperaturanwendungen geeignet, insbesondere für Temperaturen im Bereich von 200° Celsius.

Der Deckel 4 ist vorgesehen, die elektronischen Komponenten 3 und zugehörige Leiterbahnen der Leiterplatte 2 vor Ölen, Gasen und dergleichen wie eingangs beschrieben zu schützen. Insbesondere verhindert der Deckel 4, dass schwefelartige Verbindungen in den Hohlraum 5 eintreten und in Kontakt mit den elektronischen Komponenten 3 und/oder den Leiterbahnen treten können. Dabei sind kein Formschluss des Deckels 4 mit der Leiterplatte 2 und keine Dichtungen notwendig, welche keine vollständige Gasundurchlässigkeit sicherstellen würden.

Anstelle eines Metallwerkstoffs kann der Deckel 4 auch einen Kunststoffwerkstoff aufweisen. Der Kunststoffwerkstoff ist an einer der Leiterplatte 2 zugewandten Seite mit einem lötbaren Material beschichtet, sodass dieser mit der Leiterplatte 2 verlötet werden kann. Ebenso kann der Deckel 4 einen nicht lötbaren Metallwerkstoff, beispielsweise Aluminium aufweisen, welcher dann an entsprechenden Stellen mit dem lötbaren Material beschichtet ist.

Optional kann der Deckel 4 auch eine gasundurchlässige, zusätzliche Beschichtung aufweisen, welche bevorzugt an einer dem Hohlraum 5 abgewandten Außenseite des Deckels 4 aufgebracht ist. Diese Beschichtung trägt dazu bei, den Eintritt von Gasen oder Fluiden in den Hohlraum 5 zu verhindern. Insbesondere bei einem Kunststoffdeckel kann eine derartige zusätzliche Beschichtung zwingend sein.

Zur elektrischen Kopplung mit Sensoren, zum Steuern von Aktoren und/oder zur elektrischen Kopplung mit weiteren Komponenten wie beispielsweise einer Kontrolleinheit, weist die Steuergerätevorrichtung 1 jeweils einen Steckverbinder 8 auf. Der Steckverbinder 8 ist mit der Leiterplatte 2 elektrisch gekoppelt, beispielsweise mittels Pressfit Kontakten oder über eine Lötverbindung. Der Steckverbinder 8 ist außerhalb des Hohlraums 5 angeordnet.

Im Folgenden werden die Unterschiede der drei Ausführungsbeispiele gemäß den Figuren 1 bis 3 erläutert.

Im illustrativen, nicht erfindungsgemäßen Ausführungsbeispiel gemäß Figur 1 ist der Steckverbinder 8 an der Leiterplatte 2 angeordnet. Im mit der Leiterplatte 2 verlöteten Zustand des Deckels 4 ist der Deckel 4 derart ausgebildet, dass dieser den Steckverbinder 8 kraftschlüssig an der Leiterplatte 2 festlegt. Hierzu weist der Deckel 4 einen Fortsatz 9 auf. Der Steckverbinder 8 ist zumindest teilweise zwischen den Fortsatz 9 und die Leiterplatte 2 geklemmt. Die in Figur 1 gezeigte Steuergerätevorrichtung 1 ist vorgesehen innerhalb eines Getriebes montiert zu werden.

Im erfindungsgemäßen Ausführungsbeispiel gemäß Figur 2 ist die Leiterplatte 2 auf einem metallischen Grundträger 7 festgelegt. Über den metallischen Grundträger 7 kann die Leiterplatte 2 mit dem Deckel 4 mechanisch an einer weiteren Komponente, beispielsweise an einer Gehäusewandung eines Getriebes, festgelegt werden. Beispielsweise wird der Grundträger 7 mit der weiteren Komponente verschweißt, verschraubt oder andersartig montiert. Weiterhin ist der Steckverbinder 8 der Steuergerätevorrichtung 1 nicht an der Leiterplatte 2 selbst angeordnet oder mechanisch festgelegt, sondern an dem Grundträger 7. Dabei ist der Steckverbinder 8 analog zu dem illustrativen, nicht erfindungsgemäßen Ausführungsbeispiel gemäß Figur 1 über einen Fortsatz 9 des Deckels 4 kraftschlüssig an dem Grundträger 7 festgelegt. Insbesondere ist der Steckverbinder 8 festgeklemmt. Zusätzlich sind optionale Dichtungen 10 vorgesehen, die die elektrische Kopplung des Steckverbinders 8 zu der Leiterplatte 2 abdichten.

Weiter sind die elektronischen Komponenten 3 nicht auf der Leiterplatte 2, sondern auf einer zusätzlichen Leiterplatte 11 angeordnet. Die zusätzliche Leiterplatte 11 ist eine HDI-Leiterplatte (kurz für englisch: High-Density-Interconnect), welche sehr kompakt ausgestaltet ist. Die zusätzliche Leiterplatte 11 ist an der Leiterplatte 2 angeordnet. Hierbei ist die zusätzliche Leiterplatte 11 auf die Leiterplatte 2 auflaminiert. Andere Verbindungstechniken sind denkbar.

Die gezeigte Steuergerätevorrichtung 1 gemäß Figur 2 ist alternativ zusätzlich in ein Gehäuse gekapselt.

Der Steckverbinder 8 gemäß den Figuren 1 und 2 kann optional auch jeweils formschlüssig mit dem Deckel 4 mechanisch gekoppelt sein. Dadurch wird ein verbessertes mechanisches Festlegen des Steckverbinders 8 an der Leiterplatte 2 beziehungsweise an dem Grundträger 7 erreicht.

Optional kann der Steckverbinder 8 gemäß den Figuren 1 und 2 auch Teil des Deckels 4 sein. Somit sind der Steckverbinder 8 und der Deckel 4 einstückig ausgebildet. Dies spart Herstellungs- und Montagekosten ein.

In einem nicht gezeigten illustrativen, nicht erfindungsgemäßen Ausführungsbeispiel ist anstelle des in Figuren 1 und 2 gezeigten Steckverbinders 8 ein anderes Kunststoffanbauteil vorgesehen, welches mittels des Deckels 4 an der Leiterplatte 2 und/oder dem metallischen Grundträger 7 festgelegt ist.

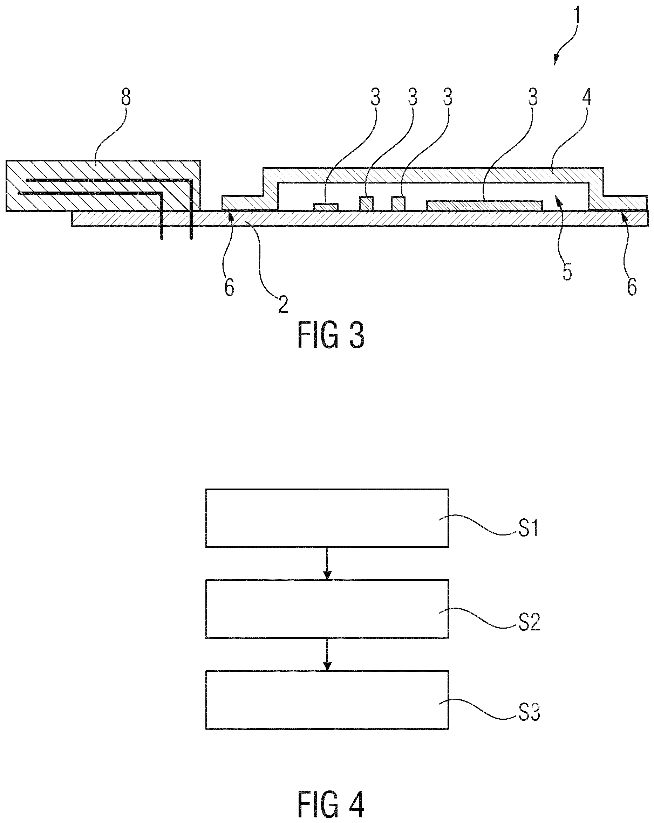

Im illustrativen, nicht erfindungsgemäßen Ausführungsbeispiel gemäß Figur 3 ist der Steckverbinder 8 nicht mittels des Deckels 4 mechanisch an der Leiterplatte 2 festgelegt. Vielmehr ist der Steckverbinder 8 selbst mechanisch an der Leiterplatte 2 festgelegt, beispielsweise mit dieser verlötet oder mittels Pressfit-Kontaktierung. Auch andere Verbindungstechniken sind denkbar, beispielsweise Schweißen. Alternativ kann die in Figur 3 gezeigte Leiterplatte 2 analog dem Ausführungsbeispiel gemäß Figur 2 auf einen metallischen Grundträger aufgebracht sein. Dabei kann der Steckverbinder 8 anstelle einer Festlegung an der Leiterplatte 2 an dem Grundträger festgelegt sein. Die in Figur 3 gezeigte Steuergerätevorrichtung 1 ist wiederum vorgesehen innerhalb eines Getriebes montiert zu werden.

Figur 4 zeigt schematisch ein Ablaufdiagramm eines Verfahrens zum Herstellen der anhand von Figuren 1 bis 3 beschriebenen Steuergerätevorrichtungen 1. Insbesondere wird das Verbinden des Deckels 4 mit der jeweiligen Steuergerätevorrichtung 1 der drei Ausführungsbeispiele beschrieben.

In einem Schritt S1 wird die Leiterplatte 2 bereitgestellt, auf welcher die elektronischen Komponenten 3 angeordnet sind.

Weiter wird der gasundurchlässige Deckel 4 bereitgestellt in einem Schritt S2.

In einem Schritt S3 wird der Deckel 4 mit einer Metalllage 6 der Leiterplatte 2 verlötet, sodass sich der abgeschlossene Hohlraum 5 ausbildet, in welchem sich die elektronischen Komponenten 3 befinden.

In Schritt S3 werden der bereitgestellte Deckel 4 und die bereitgestellte Leiterplatte 2 entsprechend angeordnet in einen Lötofen oder einen Heißlufttunnel geführt. Dabei wird Wärme in diese Steuergerätevorrichtung 1 eingebracht, insbesondere in das Lot, sodass dieses zum Herstellen der stoffschlüssigen Verbindung zwischen dem Deckel 4 und der Leiterplatte 2 aufgeschmolzen wird.

Alternativ kann anstelle des Lötens in dem Lötofen oder in dem Heißlufttunnel auch ein Laserlöten vorgesehen sein. Dabei wird mittels eines Lasers punktuell Wärmeenergie in die zu lötenden Bereiche der Steuergerätevorrichtung 1 eingebracht. Somit wird die Wärmeenergie im Wesentlichen nicht in andere Bereiche der Steuergerätevorrichtung 1 eingebracht, beispielsweise in die elektronischen Komponenten 3.

Optional kann vor dem stoffschlüssigen Verbinden die Metalllage 6 versiegelt werden, sodass ein direkter Kontakt der Metalllage 6 mit der Umgebung des Deckels 4 außerhalb des Hohlraums 5 unterbunden ist. Hierzu wird die Metalllage 6 beispielsweise mit einer zusätzlichen Beschichtung versehen und anschließend mit dem Deckel 4 verlötet. Die zusätzliche Beschichtung sorgt dafür, dass die Metalllage 6 keinen direkten Kontakt zur Umgebung des Deckels 4 außerhalb des Hohlraums 5 hat. Dadurch wird verhindert, dass die Metalllage 6 aufgrund der Öle oder Gase zersetzt wird, wodurch sich der Deckel 4 von der Leiterplatte 2 lösen und/oder die Gase oder Fluide in den Hohlraum 5 eindringen würden.

Optional wird das Versiegeln nach Schritt S3, also nach dem Verbinden vorgenommen, wobei eine Versiegelungsbeschichtung außerhalb des Hohlraums 5 aufgebracht wird, welche die Leiterplatte 2 und den Deckel 4 überlappt. Dabei überlappt die Versiegelungsbeschichtung die erwähnten Komponenten derart, dass die Metalllage 6 außerhalb des Hohlraums 5 nicht freiliegt beziehungsweise Kontakt zur Umgebung des Deckels 4 hat.

## Patentansprüche

1. Steuergerätevorrichtung (1) für ein Kraftfahrzeug, aufweisend
- eine Leiterplatte (2), auf welcher mehrere elektronische Komponenten (3) angeordnet sind, welche elektrisch miteinander über Leiterbahnen der Leiterplatte (2) gekoppelt sind, wobei die Leiterplatte (2) auf einem metallischen Grundträger (7) angeordnet ist; und
- einen im Wesentlichen gasundurchlässigen Deckel (4), welcher stoffschlüssig mit der Leiterplatte (2) derart verbunden ist, dass dieser mit der Leiterplatte (2) einen abgeschlossenen Hohlraum (5) bildet, in welchem sich die elektronischen Komponenten (3) und die zugehörigen Leiterbahnen befinden,
**dadurch gekennzeichnet, dass**
die Steuergerätevorrichtung (1) weiter einen Steckverbinder (8) aufweist, welcher an dem Grundträger (7) angeordnet ist und elektrisch mit der Leiterplatte (2) gekoppelt ist, wobei der Deckel (4) derart ausgestaltet ist, dass dieser im mit der Leiterplatte (2) verbundenen Zustand den Steckverbinder (8) außerhalb des Hohlraums (5) mechanisch an dem Grundträger (7) festlegt.

2. Steuergerätevorrichtung (1) nach Anspruch 1, wobei die stoffschlüssige Verbindung zwischen dem Deckel (4) und der Leiterplatte (2) mittels Schweißen hergestellt ist.

3. Steuergerätevorrichtung (1) nach Anspruch 1, wobei die stoffschlüssige Verbindung zwischen dem Deckel (4) der Leiterplatte (2) mittels Löten hergestellt ist, wobei eine Metalllage (6) der Leiterplatte (2) mittels eines Lots mit dem Deckel (4) verlötet ist.

4. Steuergerätevorrichtung (1) nach Anspruch 3, wobei das Löten ein Laserlöten umfasst.

5. Steuergerätevorrichtung (1) nach Anspruch 3 oder 4, wobei die Metalllage (6) zumindest in einem dem Hohlraum (5) abgewandten Bereich versiegelt ist, sodass ein Kontakt der Metalllage (6) mit einer Umgebung des Deckels (4) außerhalb des Hohlraums (5) unterbunden ist.

6. Steuergerätevorrichtung (1) nach einem der vorhergehenden Ansprüche, wobei der Deckel (4) einen Metallwerkstoff oder einen Kunststoffwerkstoff aufweist.

7. Steuergerätevorrichtung (1) nach Anspruch 6, wobei der Deckel (4) zum Herstellen der stoffschlüssigen Verbindung an einer der Leiterplatte (2) zugewandten Seite mit einem lötbaren Material beschichtet ist.

8. Steuergerätevorrichtung (1) nach einem der Ansprüche 6 oder 7, wobei der Deckel (4) eine gasundurchlässige Beschichtung aufweist.

9. Verfahren zum Herstellen einer Steuergerätevorrichtung (1) nach einem der Ansprüche 1 bis 8, umfassend
- Bereitstellen der Leiterplatte (2), auf welcher die elektronischen Komponenten (3) angeordnet sind;
- Bereitstellen des gasundurchlässigen Deckels (4);
- stoffschlüssiges Verbinden des Deckels (4) mit der Leiterplatte (2) derart, dass dieser mit der Leiterplatte (2) einen abgeschlossenen Hohlraum (5) bildet, in welchem sich die elektronischen Komponenten (3) befinden.

10. Verfahren nach Anspruch 9, wobei das Verbinden ein Schweißen umfasst.

11. Verfahren nach Anspruch 9, wobei das Verbinden ein Löten, insbesondere ein Laserlöten, umfasst, wobei eine Metalllage (6) der Leiterplatte (2) mittels eines Lots mit dem Deckel (4) verlötet wird.

12. Verfahren nach Anspruch 11, wobei vor dem Verbinden die Metalllage (6) versiegelt wird zum Unterbinden eines direkten Kontakts der Metalllage (6) mit einer Umgebung des Deckels (4) außerhalb des Hohlraums (5).

13. Verfahren nach einem der Ansprüche 9 bis 12, wobei nach dem Verbinden eine Versiegelungsbeschichtung außerhalb des Hohlraums (5) derart aufgebracht wird, dass diese die Leiterplatte (2) und den Deckel (D) zum Versiegeln der Metalllage (6) überlappt.

## Claims

1. Control unit device (1) for a motor vehicle, having
- a circuit board (2) on which a plurality of electronic components (3) are arranged, which electronic components are electrically coupled to one another via conductor tracks of the circuit board (2), wherein the circuit board (2) is arranged on a metallic base carrier (7); and
- an essentially gas-impermeable cover (4) which is connected in a materially joined fashion to the circuit board (2) in such a way that said cover (4) forms with the circuit board (2) a closed cavity (5) in which the electronic components (3) and the associated conductor tracks are located,
**characterized in that**
the control unit device (1) also has a plug connector (8) which is arranged on the base carrier (7) and electrically coupled to the circuit board (2), wherein the cover (4) is configured in such a way that, in the state in which it is connected to the circuit board (2), it secures the plug connector (8) mechanically to the base carrier (7) outside the cavity (5).

2. Control unit device (1) according to Claim 1, wherein the materially joined connection between the cover (4) and the circuit board (2) is produced by means of welding.

3. Control unit device (1) according to Claim 1, wherein the materially joined connection between the cover (4) and the circuit board (2) is produced by means of soldering, wherein a metal layer (6) of the circuit board (2) is soldered to the cover (4) by means of a solder.

4. Control unit device (1) according to Claim 3, wherein the soldering comprises laser soldering.

5. Control unit device (1) according to Claim 3 or 4, wherein the metal layer (6) is sealed at least in a region facing away from the cavity (5), with the result that contact of the metal layer (6) with the surroundings of the cover (4) outside the cavity (5) is prevented.

6. Control unit device (1) according to one of the preceding claims, wherein the cover (4) has a metal material or a plastic material.

7. Control unit device (1) according to Claim 6, wherein, in order to produce the materially joined connection, the cover (4) is coated with a solderable material on a side facing the circuit board (2).

8. Control unit device (1) according to one of Claims 6 or 7, wherein the cover (4) has a gas-impermeable coating.

9. Method for manufacturing a control unit device (1) according to one of Claims 1 to 8, comprising
- making available the circuit board (2) on which the electronic components (3) are arranged;
- making available the gas-impermeable cover (4);
- connecting the cover (4) to the circuit board (2) in a materially joined fashion such that the cover (4) forms, with the circuit board (2), a closed cavity (5) in which the electronic components (3) are located.

10. Method according to Claim 9, wherein the connecting operation comprises welding.

11. Method according to Claim 9, wherein the connecting operation comprises soldering, in particular laser soldering, wherein a metal layer (6) of the circuit board (2) is soldered to the cover (4) by means of a solder.

12. Method according to Claim 11, wherein, before the connecting operation, the metal layer (6) is sealed in order to prevent direct contact of the metal layer (6) with the surroundings of the cover (4) outside the cavity (5).

13. Method according to one of Claims 9 to 12, wherein, after the connecting operation, a sealing coating is applied outside the cavity (5) in such a way that it overlaps with the circuit board (2) and the cover (D) in order to seal the metal layer (6).

## Revendications

1. Dispositif de commande (1) destiné à un véhicule automobile et comprenant
- une carte de circuit imprimé (2) sur laquelle sont disposés une pluralité de composants électroniques (3) qui sont couplés électriquement entre eux par le biais de pistes conductrices de la carte de circuit imprimé (2), la carte de circuit imprimé (2) étant disposée sur un support de base métallique (7) ; et
- un couvercle (4) sensiblement imperméable aux gaz qui est relié par une liaison de matière à la carte de circuit imprimé (2) de manière à former avec la carte de circuit imprimé (2) une cavité fermée (5) dans laquelle se trouvent les composants électroniques (3) et les pistes conductrices,
**caractérisé en ce que**
le dispositif de commande (1) comporte en outre un connecteur enfichable (8) qui est disposé sur le support de base (7) et qui est couplé électriquement à la carte de circuit imprimé (2), le couvercle (4) étant conçu de manière à fixer mécaniquement, lorsqu'il est relié à la carte de circuit imprimé (2), le connecteur (8) à l'extérieur de la cavité (5) sur le support de base (7).

2. Dispositif de commande (1) selon la revendication 1, la liaison de matière entre le couvercle (4) et la carte de circuit imprimé (2) étant réalisée par soudage.

3. Dispositif de commande (1) selon la revendication 1, la liaison de matière entre le couvercle (4) et la carte de circuit imprimé (2) étant réalisée par brasage, une couche métallique (6) de la carte de circuit imprimé (2) étant brasée au couvercle (4) au moyen d'une soudure.

4. Dispositif de commande du dispositif (1) selon la revendication 3, le brasage comprenant un brasage laser.

5. Dispositif de commande (1) selon la revendication 3 ou 4, la couche métallique (6) étant scellée au moins dans une zone opposée à la cavité (5) de façon à empêcher le contact de la couche métallique (6) avec l'environnement du couvercle (4) à l'extérieur de la cavité (5).

6. Dispositif de commande (1) selon l'une des revendications précédentes, le couvercle (4) comprenant une matière métallique ou une matière synthétique.

7. Dispositif de commande (1) selon la revendication 6, le couvercle (4) étant revêtu d'une matière apte au brasage pour réaliser la liaison de matière sur un côté tourné vers la carte de circuit imprimé (2).

8. Dispositif de commande (1) selon l'une des revendications 6 et 7, le couvercle (4) comportant un revêtement imperméable aux gaz.

9. Procédé de fabrication d'un dispositif de commande (1) selon l'une des revendications 1 à 8, le procédé comprenant les opérations suivantes :
- fournir la carte de circuit imprimé (2) sur laquelle sont disposés les composants électroniques (3) ;
- fournir le couvercle (4) imperméable aux gaz ;
- réaliser une liaison de matière entre le couvercle (4) et la carte de circuit imprimé (2) de façon à former avec la carte de circuit imprimé (2) une cavité fermée (5) dans laquelle se trouvent les composants électroniques (3).

10. Procédé selon la revendication 9, la liaison comprenant un soudage.

11. Procédé selon la revendication 9, la liaison comprenant un brasage, en particulier un brasage laser, une couche métallique (6) de la carte de circuit imprimé (2) étant soudée au couvercle (4) au moyen d'une brasure.

12. Procédé selon la revendication 11, la couche métallique (6) étant scellée avant de réaliser la liaison afin d'éviter un contact direct de la couche métallique (6) avec l'environnement du couvercle (4) à l'extérieur de la cavité (5).

13. Procédé selon l'une des revendications 9 à 12, un revêtement de scellement étant appliqué à l'extérieur de la cavité (5), après que la liaison a été réalisée, de façon à chevaucher la carte de circuit imprimé (2) et le couvercle (D) pour sceller la couche métallique (6).
